# EUROPEAN PATENT APPLICATION

(11) **EP 2 717 061 A1**
(43) Date of publication of application: **09.04.2014**
(21) Application number: 11874094.3
(22) Date of filing: 12.10.2011
(51) Int. Cl.: G01R 1/04, G01R 11/04, G01R 35/04

(54) **WORKPIECE TRAY OF CONCENTRATOR OR SPECIAL TRANSFORMER ACQUISITION TERMINAL**

(71) Applicant: State Grid Corporation of China, Beijing 100031 (CN); Jibei Electric Power Company Limited Center of Metrology, Beijing 100045 (CN); Hangzhou Houda Automatic System Co., Ltd., Yuhang District Hangzhou City Zhejiang 310023 (CN)
(72) Inventor: SONG, Wei, Beijing 100045 (CN); CHEN, Linsheng, Hangzhou Zhejiang 310023 (CN); WANG, Sitong, Beijing 100045 (CN); XU, Zhanhe, Beijing 100045 (CN); ZHOU, Panpan, Hangzhou Zhejiang 310023 (CN); WANG, Jiangtao, Hangzhou Zhejiang 310023 (CN); LU, Guanna, Beijing 100045 (CN); DING, Hengchun, Beijing 100045 (CN); ZHANG, Luhua, Beijing 100045 (CN); SUN, Zhijie, Beijing 100045 (CN)
(74) Representative: Bettinger Schneider Schramm
(86) International application number: PCT/CN2011/080680
(87) International publication number: WO 2013/053112

(57) **Abstract**

A workpiece tray of a concentrator or a special transformer acquisition terminal comprises a tray body (1). A 232-port conversion terminal (2), a 232-port plug (5) and a positioning structure used for positioning the concentrator or special transformer acquisition terminal (7) are arranged on the tray body (1). The 232-port conversion terminal (2) and the 232-port plug (5) are connected through a wire. The 232-port plug (5) is flexibly inserted at the tray body (1). An automatic wire retraction mechanism is further arranged on the tray body (1). When the 232-port plug (5) is plugged or pulled, the wire connected to the 232-port plug (5) automatically stretches or retracts under the effect of the automatic wire retraction mechanism. Owing to the automatic wire retraction mechanism arranged on the tray body (1), the wire does not affect picking and placing of the ammeter. Hence, the 232-port plug (5) becomes a part of the workpiece tray. Therefore, the tray not only implements universal usage of the special transformer acquisition terminal and concentrator and reduces the usage of the tray, but also completes the verification of the special transformer acquisition terminal and concentrator on the same verification line, thereby reducing the cost.

## Description

### TECHNICAL FIELD

The invention generally relates to a tray.

### BACKGROUND

In order to complete the verification of a concentrator or special transformer acquisition terminal, the 232-port plug should operate with a tray. In other words, the 232-port plug should not be pulled out from the ammeter until the verification is complete. Thus, the 232-port plug should become a part of the workpiece tray.

### SUMMARY

The present invention implies to solve the aforementioned technical problem and provide a workpiece tray for a concentrator or special transform acquisition terminal so that a 232-port plug becomes a part of the tray, and is not affected by the picking and placing of the ammeter.

In order to solve the aforementioned problem, the workpiece tray for a concentrator or special transformer acquisition terminal is provided, which comprises a tray body. A 232-port conversion terminal, a 232-port plug, and a positioning structure for positioning the concentrator or special transformer acquisition terminal is arranged on the tray body. The 232-port plug conversion terminal and the 232-port plug are connected through a wire, and the 232-port plug is flexibly inserted at the tray body. An automatic wire retraction mechanism is further arranged on the tray body. When the 232-port plug is plugged or pulled, the wire connected to the 232-port automatically stretches or retracts under the effect of the automatic wire retraction mechanism.

In a preferred embodiment of the present invention, the positioning structure is a set of positioning pins disposed at both the front and the back sides of the tray body. Each set of the positioning pins correspondingly defines a position for the concentrator or special transformer acquisition terminal. Two 232-port conversion terminals are disposed in parallel in the middle part of the tray body respectively, and two reels are disposed at the left and right sides of the middle part of the tray body respectively. A positioning pin, the bottom of which connects with the tray body through screw thread, is disposed between the reel and 232-port conversion terminal. Two 232-port plugs are disposed beside the two reels respectively.

In a preferred embodiment of the present invention, two guide plates are disposed at the boardsides of the reel respectively. A space between the two guide plates can accommodate 3 to 4 cycles of the wire with diameter from Φ3 to Φ4. A hole with diameter Φ4 is formed on the outer peripheral surface of the reel along the direction perpendicular to the axes center of the reel, and another hole with Φ4 is formed at a side of the reel axle, where the two holes form a through hole. A coil spring is disposed at another side of the reel axle, which is designed so that the wire tensioning force given by the torsion force which generated by wrapping 4 cycles being no more than 10N. One terminal of the wire is collected to the 232-port conversion terminal positioned in the middle of the tray body after passing through the two Φ4 holes which are perpendicular to each other and going through the wire casing of the tray, while another terminal of the wire connects with the 232-port plug after wrapping a plurality of cycles around the reel and keeps straight.

In a preferred embodiment of the present invention, the bottom of the 232-port conversion terminal is predetermined with wiring terminals for matching with various special apparatus.

In a preferred embodiment of the present invention, two equal-height positioning blocks are disposed in the front and rear side of the tray body respectively, and both of the positioning pins disposed in the middle of the tray body are long positioning pins which has a height larger than the positioning pins and matches up with equal-height positioning blocks in order to locate with each other when the empty trays are stacking.

In a preferred embodiment of the present invention, a slide plate used for accommodating the concentrator or special transformer acquisition terminal is disposed on the tray body. The slide plate slides within a slide slot of the tray body, wherein an L-shape structure used for hanging on the concentrator or special transformer acquisition terminal is disposed at the front end of the slide plate body. A hooking spring is provided, one end of which connects with the slide plate and another end is fixed onto the tray body.

In view of the similar profile of special transformer acquisition terminal and the concentrator, as well as the similar verification procedure, improvement is implemented to the pattern of the workpiece tray. Corresponding to the screw thread connection between the bottom of the position pins and the tray body, when the ammeter is positioned, positioning pins with different diameters are used in correspondence with the special transformer acquisition terminal or concentrator respectively. Owing to the automatic wire retraction mechanism arranged on the tray body, the wire does not affect picking and placing of the ammeter. Hence, the 232-port plug becomes a part of the tray. Therefore, the tray not only implements universal usage of the special transformer acquisition terminal and concentrator and reduces the usage of the tray, but also completes the verification of the special transformer acquisition terminal and concentrator on the same verification line, thereby reducing the cost.

The above described features and advantages, as well as others, will become more readily apparent to the skilled in the art by reference to the following description and accompanying drawings.

### BRIEF DESCRIPTION OF THE DRAWINGS

FIG.1 shows a representative top view of the invention;
FIG.2 shows a representative side view of the invention;
FIG.3 shows a representative sectional view from the A-A dash line in FIG.1;
FIG.4 shows a representative sectional view from the B-B dash line in FIG.1;
FIG.5 shows a representative top view of the invention on positioning a concentrator therein, wherein the middle part of the tray is not illustrated; and
FIG.6 shows a representative top view of the invention on positioning a special transformer acquisition terminal therein, wherein the middle part of the tray is not illustrated.

### DETAILED DESCRIPTION OF THE PREFERRED EMBODIMENTS

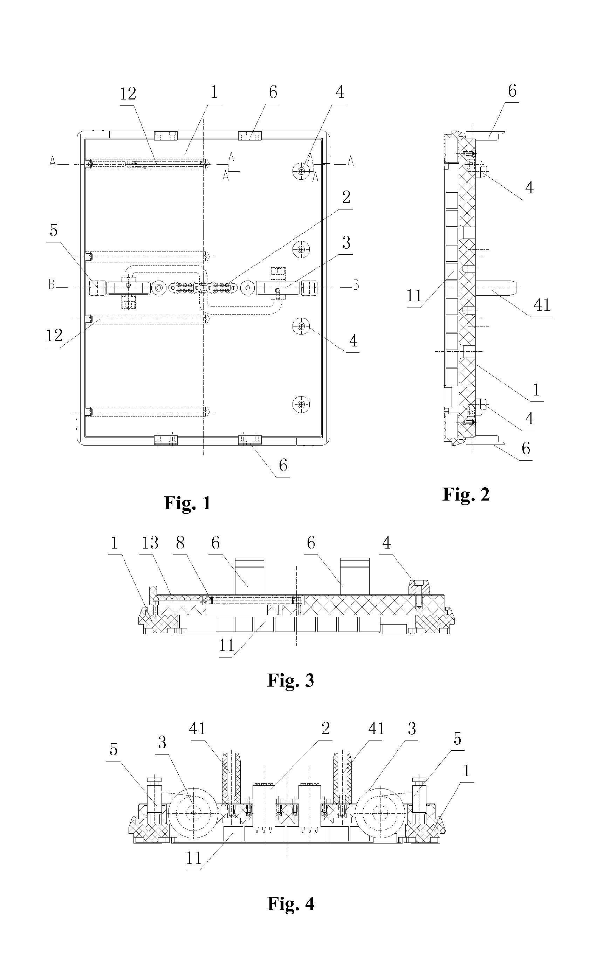

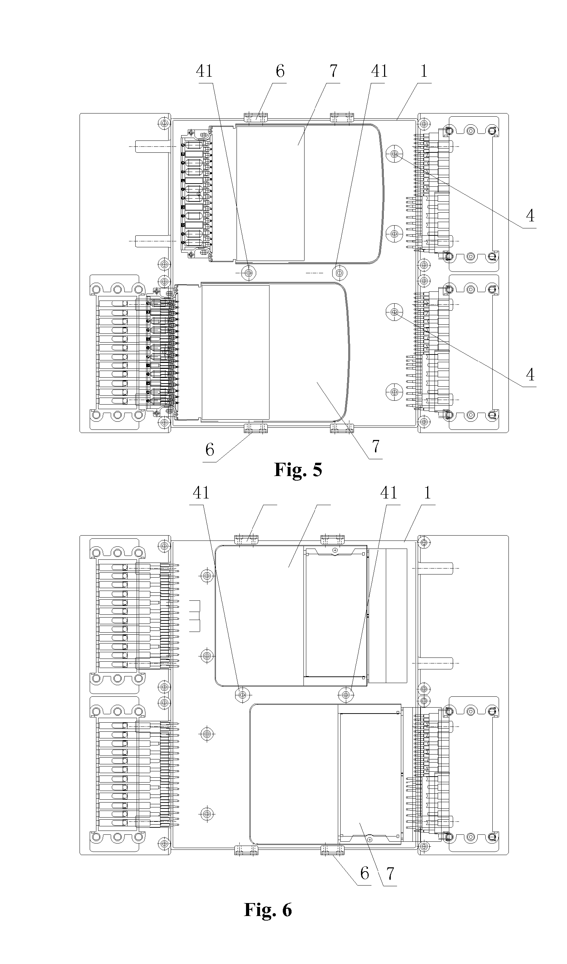

Embodiments of the invention will be illustrated in reference with fig.1 to 6. A workpiece tray for a concentrator or special transformer acquisition terminal is provided, which comprises a tray body 1. A 232-port conversion terminal 2, a 232-port plug 5, and a positioning structure for positioning the concentrator or special transformer acquisition terminal 7 are arranged on the tray body. The 232-port conversion terminal and the 232-port plug are connected with a wire. The 232-port plug is flexibly inserted at the tray body. An automatic wire retraction mechanism is further arranged on the tray body. When the 232-port plug is plugged or pulled, the wire connected to the 232-port plug automatically stretches or retracts under the effect of the automatic wire retraction mechanism.

In a preferred embodiment of the present invention, the positioning structure is a set of positioning pins disposed at both the front and the back sides of the tray body. Each set of positioning pins correspondingly defines a position for the concentrator or special transformer acquisition terminal. Two 232-port conversion terminals 2 are disposed in parallel in the middle part of the tray body respectively, and two reels 3 are disposed at the left and right sides of the middle part of the tray body respectively. A positioning pin, the bottom of which connects with the tray body through screw thread, is disposed between the reel and 232-port conversion terminal. Two 232-port plugs 5 are disposed beside the two reels respectively.

In a preferred embodiment of the present invention, two guide plates are disposed at the boardsides of the reels respectively. A space formed between the two guide plates can accommodate 3 to 4 cycles of the wire with diameter from Φ3 to Φ4. A hole with diameter Φ4 is formed in the outer peripheral surface of the reel along the direction in perpendicular to the axes center of the reel, and another hole with diameter Φ4 is formed at a side of the reel axle, where the two holes form a through hole. A coil spring is disposed at another side of the reel axle, which is designed so that the wire tensioning force given by the torsion force generated by wrapping 4 cycles being no more than 10N. One terminal of the wire is collected to the 232-port conversion terminal positioned in the middle of the tray body after passing through the two holes with diameter Φ4 perpendicular to each other and going through the wire casing of the tray, while the other terminal of the wire connects with the 232-port plug after wrapping a plurality of cycles around the reel and keeps straight. The bottom of the 232-port conversion terminal is predetermined with wiring terminals for matching with various special apparatus.

In a preferred embodiment of the present invention, two equal-height positioning blocks 6 are disposed in the front and rear side of the tray body respectively. Both of the positioning pins 41 disposed in the middle of the tray body are long positioning pins which have a height larger than the positioning pins 4 and matches up with equal-height positioning blocks in order to locate with each other when the empty trays are stacking.

Since the concentrator or special transformer acquisition terminal requires resetting after verification, a reset device is disposed on the tray. A slide plate 13 used for accommodating the concentrator or special transformer acquisition terminal is disposed on the tray body. The slide plate slides within a slide slot 12 of the tray body, wherein an L-shape structure used for hanging on the concentrator or special transformer acquisition terminal is disposed at the front end of the slide plate body. A hooking spring 8 is provided, one end of which connects with the slide plate and another end is fixed onto the tray body.

Due to the similar profile of special transformer acquisition terminal and the concentrator, as well as the similar conversion program, the pattern of corresponding workpiece trays are similar, referring to the schematic of the workpiece tray of the concentrator and the special transformer acquisition terminal. After all appearance differences are existing between them, positioning pins with different diameters are used in correspondence with the special transformer acquisition terminal or concentrator respectively. Thus the tray becomes a different tray.

In order to complete the verification of a concentrator or special transformer acquisition terminal, the 232-port plug should operate with a tray. In other words, the 232-port plug should not be pulled out from the electricity ammeter until the verification is complete. Thus, the 232-port plug should become a part of the workpiece tray.

In order to retract and release the wires, as illustrated in the drawings, two reels are disposed at the right and left sides in the middle part of the pallet body respectively, wherein two guide plates are disposed at the boardsides of the reels respectively, a space between the two guide plates can accommodate 3 to 4 cycles of the wire with diameter from Φ3 to Φ4. A hole with diameter Φ4 is formed in the outer peripheral surface of the reel along the direction perpendicular to the axes center of the reel, and the another hole with diameter Φ4 is formed at a side of the reel axle, where the two holes form a through hole. A coil spring is disposed at the other side of the reel axle, which is designed so that the wire tensioning force given by the torsion force generated by wrapping 4 cycles is no more than 10N. One terminal of the wire is collected to the 232-port conversion terminal positioned in the middle of the tray body after passing through the two holes with diameter Φ4 which are perpendicular to each other and going through the wire casing of the tray, while the other terminal of the wire connects with the 232-port plug after wrapping a plurality of cycles around the reels and keeps straight. The bottom of the 232-port conversion terminal matches with the lifting apparatus which are arranged on various wire work stations, thereby realizes connection between work station systems and helps the system to perform the signal interaction.

Since the conversion of the special transformer acquisition terminal and concentrator are completed on the same verification line, the interchanging and storing of various batches of empty trays should be solved. In order to save the storing space, empty trays should be stacked. The trays for concentrator or special transformer acquisition terminal are stacked by using long positioning pins and setting equal-height positioning blocks all around to realize supporting and positioning, wherein the long positioning pin is inserted into a groove at bottom of a tray, and the top portion of the positioning block is of L-shape.

The long positioning pins possess two functions of which firstly positioning and guiding a meter to execute normal crimping procedure and secondly supporting and inter-positioning during the stacking of empty workpiece tray. In addition, four equal-height position blocks are further disposed all around the tray for the stacking of empty trays.

It will be appreciated that the automatic wire retraction mechanism is not merely limited within these and other preferred embodiment as illustrated above, and may be alternated with connecting a supporting hammer with the end of wire. As for positioning structure used for positioning the concentrator or special transformer acquisition terminal 7, a positioning case can also be used to set the concentrator or special transformer acquisition therein.

## Claims

1. A workpiece tray used for a concentrator or special transformer acquisition terminal, which comprises a tray body (1); a 232-port conversion terminals (2), a 232-port plugs (5), and a positioning structure for positioning the concentrator or special transformer acquisition terminal (7) are arranged on the tray body; said 232-port conversion terminal (5) and the 232-port plug are connected with a wire,
**characterized in that**
the 232-port plug (5) is flexibly inserted at the tray body (1);
an automatically wire retracting mechanism is further arranged on the tray body;
when the 232-port is plugged or pulled, the wire connected to the 232-port plug automatically stretches or retracts under the effect of the automatic wire retraction mechanism.

2. The workpiece tray used for a concentrator or special transformer acquisition terminal of claim 1, wherein the positioning structure is a set of positioning pins (4) disposed at both the front and rear sides of the tray body, each set of the positioning pins correspondingly defines a position for the concentrator or special transformer acquisition terminal; two 232-port conversion terminals (2) are disposed in parallel in the middle part of the tray body respectively, and two reels (3) are disposed at the left and right sides of the middle part of the tray body respectively; a positioning pin (4), the bottom of which connects with the tray body (1) through screw thread, is disposed between the reel and 232-port conversion terminal; two 232-port plugs (5) are disposed beside the two reels (3) respectively.

3. The workpiece tray used for a concentrator or special transformer acquisition terminal of claim 2, wherein two guide plates are disposed at the boardsides of the reel (3) respectively; a space between the two guide plates can accommodate 3 to 4 cycles of the wire with diameter from Φ3 to Φ4; a hole with diameter Φ4 is formed in the outer peripheral surface of the reel along the direction perpendicular to the axes center of the reel, and another hole with diameter Φ4 is formed at a side of the reel axle, where the two holes form a through hole; a coil spring is disposed at the other side of the reel axle, which is designed so that the wire tensioning force from the torsion force generated by wrapping 4 cycles is no more than 10N; one terminal of the wire is collected to the 232-port conversion terminal positioned in the middle of the tray body after passing through the two holes with diameter Φ4 which are perpendicular to each other and going through the wire casing of the tray, while another terminal of the wire connects with the 232-port plug after wrapping a plurality of cycles around the reel and keeps straight.

4. The workpiece tray used for a concentrator or special transformer acquisition terminal of claim 2, wherein the bottom of the 232-port conversion terminal (2) is predetermined with wiring terminals for matching with various special apparatuses.

5. The workpiece tray used for a concentrator or special transformer acquisition terminal of claim 2, wherein two equal-height positioning blocks (6) are disposed in the front and rear sides of the tray body (1) respectively; both of the positioning pins disposed in the middle of the tray body are long positioning pins (41) which have a height larger than the positioning pins (4) and matches up with equal-height positioning blocks in order to locate with each other when the empty trays are stacking.

6. The workpiece tray used for a concentrator or special transformer acquisition terminal of claim 2, wherein a slide plate (13) used for accommodating the concentrator or special transformer acquisition terminal (7) is disposed on the tray body (1); the slide plate slides within a slide slot (12) of the tray body; wherein a L-shape structure used for hanging on the concentrator or special transformer acquisition terminal is disposed at the front end of the slide plate; a hooking spring (8) is provided, one end of which connects with the slide plate (13) and the other end is fixed onto the tray body (1).
